(19) Europäisches Patentamt
European Patent Office
Office européen des brevets

(11) **EP 3 513 208 B1**

(12) **EUROPÄISCHE PATENTSCHRIFT**

(45) Veröffentlichungstag und Bekanntmachung des Hinweises auf die Patenterteilung:
**18.05.2022   Patentblatt 2022/20**

(21) Anmeldenummer: **17764554.6**

(22) Anmeldetag: **06.09.2017**

(51) Internationale Patentklassifikation (IPC):
**G01R 31/382** (2019.01)    **G01R 19/165** (2006.01)
**H01M 10/48** (2006.01)

(52) Gemeinsame Patentklassifikation (CPC):
**G01R 19/16542; G01R 31/382; H01M 10/482;
H01M 10/486;** Y02E 60/10; Y02T 10/70

(86) Internationale Anmeldenummer:
**PCT/EP2017/072311**

(87) Internationale Veröffentlichungsnummer:
**WO 2018/050505 (22.03.2018 Gazette 2018/12)**

(54) **VERFAHREN ZUM BETRIEB EINER BATTERIEZELLE**

METHOD FOR OPERATING A BATTERY CELL

PROCÉDÉ DE FONCTIONNEMENT D'UN ÉLÉMENT DE BATTERIE

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **15.09.2016   DE 102016217572**

(43) Veröffentlichungstag der Anmeldung:
**24.07.2019   Patentblatt 2019/30**

(73) Patentinhaber: **Robert Bosch GmbH
70442 Stuttgart (DE)**

(72) Erfinder: **SALZIGER, Jan
71679 Asperg (DE)**

(56) Entgegenhaltungen:
**DE-A1- 19 521 962        DE-A1-102011 084 777
US-A- 5 362 942          US-A1- 2013 257 350
US-A1- 2014 253 046**

**Beschreibung**

Die Erfindung betrifft ein Verfahren zum Betrieb einer Batteriezelle, insbesondere in einem Fahrzeug, wobei mittels eines Temperatursensors eine Temperatur der Batteriezelle gemessen wird, und zur Ermittlung eines durch die Batteriezelle fließenden Batteriestroms mittels eines Stromsensors ein Messstrom gemessen wird.

Stand der Technik

Elektrische Energie ist mittels Batterien speicherbar. Batterien wandeln chemische Reaktionsenergie in elektrische Energie um. Hierbei werden Primärbatterien und Sekundärbatterien unterschieden. Primärbatterien sind nur einmal funktionsfähig, während Sekundärbatterien, die auch als Akkumulator bezeichnet werden, wieder aufladbar sind. Eine Batterie umfasst dabei eine oder mehrere Batteriezellen.

Sekundärbatterien kommen unter anderem in Kraftfahrzeugen, insbesondere in Elektrofahrzeugen (Electric Vehicle, EV), Hybridfahrzeugen (Hybride Electric Vehicle, HEV) sowie Plug-In-Hybridfahrzeugen (Plug-In-Hybride Electric Vehicle, PHEV) zum Einsatz.

Batteriezellen weisen eine positive Elektrode, die auch als Kathode bezeichnet wird, und eine negative Elektrode, die auch als Anode bezeichnet wird, auf. Die Kathode sowie die Anode umfassen je einen Stromableiter, auf den ein Aktivmaterial aufgebracht ist. Die Stromableiter der beiden Elektroden sind mittels Kollektoren elektrisch mit Polen der Batteriezelle, welche auch als Terminals bezeichnet werden, verbunden.

Im Betrieb der Batteriezelle fließt ein Batteriestrom von dem positiven Terminal in einem äußeren Stromkreis zu dem negativen Terminal. Bei einem Entladevorgang der Batteriezelle ist der Batteriestrom positiv, und bei einem Ladevorgang der Batteriezelle ist der Batteriestrom negativ.

Im Stand der Technik bekannte Batteriezellen sind nur in einem begrenzten Arbeitstemperaturbereich optimal betreibbar. Zu hohe Temperaturen können irreversible chemische Reaktionen auslösen, was zu einem Kapazitätsverlust oder gar zu einer Zerstörung der Batteriezelle führen kann. Bei zu tiefen Temperaturen kann die Leistung der Batteriezelle vermindert sein. Insbesondere können viele Arten von Batteriezellen beim Laden unterhalb einer Grenztemperatur von beispielsweise 0°C beschädigt werden.

Zur Ermittlung des durch die Batteriezelle fließenden Batteriestroms kommen Stromsensoren zum Einsatz. Stromsensoren weisen, insbesondere beim Messen von verhältnismäßig kleinen Strömen, eine Toleranz auf, welche sich in Form eines Messfehlerstroms auswirkt. Wird also ein verhältnismäßig kleiner Messstrom gemessen, so ist aufgrund der Toleranz nicht sicher, ob die Batteriezelle geladen oder entladen wird.

Um also ein Laden der Batteriezelle bei einer Temperatur unterhalb der Grenztemperatur von beispielsweise 0°C sicher zu verhindern, müsste die Batteriezelle abgeschaltet werden, wenn der gemessene Messstrom kleiner als der Messfehlerstrom ist.

Ein Verfahren zum Betrieb einer Batteriezelle aus dem Stand der Technik ist in US 2013/257350 A1 offenbart.

Offenbarung der Erfindung

Die Erfindung ist durch die unabhängigen Ansprüche definiert. Es wird ein Verfahren zum Betrieb einer Batteriezelle, insbesondere in einem Fahrzeug, vorgeschlagen, wobei mittels eines Temperatursensors eine Temperatur der Batteriezelle gemessen wird, und zur Ermittlung eines durch die Batteriezelle fließenden Batteriestroms mittels eines Stromsensors ein Messstrom gemessen wird. Wenn der Batteriestrom positiv ist, so wird die Batteriezelle entladen. Wenn der Batteriestrom negativ ist, so wird die Batteriezelle geladen.

Wenn die gemessene Temperatur eine Grenztemperatur unterschreitet, und wenn der gemessene Messstrom einen vorgegebenen Grenzwert unterschreitet, so wird ein Verbraucher mit der Batteriezelle verbunden, wodurch der Verbraucher von einem Verbraucherstrom aus der Batteriezelle durchflossen wird. Die Batteriezelle liefert dadurch zusätzlich den durch den Verbraucher fließenden Verbraucherstrom, wodurch der durch die Batteriezelle fließende Batteriestrom erhöht wird.

Gemäß der Erfindung entspricht der vorgegebene Grenzwert dabei einem Messfehlerstrom des Stromsensors. Der Messfehlerstrom ist dabei insbesondere die maximale Abweichung des Messstroms von dem Batteriestrom. Somit ist sichergestellt, dass der Batteriestrom vor dem Verbinden des Verbrauchers mit der Batteriezelle nicht negativ wird, und dass die Batteriezelle vor dem Verbinden des Verbrauchers mit der Batteriezelle nicht geladen wird.

Vorzugsweise ist der Verbraucherstrom dabei mindestens so groß ist wie der vorgegebene Grenzwert. Dadurch wird der Batteriestrom beim Verbinden des Verbrauchers mit der Batteriezelle mindestens um den vorgegebenen Grenzwert erhöht.

Gemäß einer vorteilhaften Weiterbildung der Erfindung wird der Verbraucher von der Batteriezelle getrennt, wenn der gemessene Messstrom einen vorgegebenen Schwellwert überschreitet. Somit wird die Batteriezelle geschont und nicht unnötig entladen.

Bevorzugt entspricht der vorgegebene Schwellwert dabei der Summe des vorgegebenen Grenzwerts und des Verbraucherstroms. Somit ist sichergestellt, dass der Batteriestrom nach dem Trennen des Verbrauchers von der Batteriezelle nicht negativ wird, und dass die Batteriezelle nach dem Trennen des Verbrauchers von der Batteriezelle nicht geladen wird.

Gemäß einer vorteilhaften Ausgestaltung der Erfindung entspricht die Grenztemperatur einem Wert von 0°C. Für viele Arten von Batteriezellen ist 0°C die Grenztemperatur, unterhalb der die Batteriezelle beim Laden beschädigt werden kann.

Gemäß einer vorteilhaften Weiterbildung der Erfindung wird der Verbraucher von der Batteriezelle getrennt, wenn die gemessene Temperatur die Grenztemperatur überschreitet. Somit wird die Batteriezelle geschont und nicht unnötig entladen.

Bevorzugt ist der Verbraucher dabei eine Heizung zur Erwärmung der Batteriezelle. Somit kann mittels des Verbraucherstroms die Batteriezelle bis über die Grenztemperatur erwärmt werden. Nach Erreichen der Grenztemperatur kann die Batteriezelle wieder geladen werden.

Gemäß einer bevorzugten Weiterbildung der Erfindung wird die Batteriezelle abgeschaltet, wenn bei mit der Batteriezelle verbundenem Verbraucher der gemessene Messstrom den vorgegebenen Grenzwert unterschreitet. Dadurch ist sichergestellt, dass der Batteriestrom auch bei mit der Batteriezelle verbundenem Verbraucher nicht negativ wird, und dass die Batteriezelle auch bei mit der Batteriezelle verbundenem Verbraucher nicht geladen wird.

Das erfindungsgemäße Verfahren findet vorteilhaft Verwendung in einem Elektrofahrzeug (EV), in einem Hybridfahrzeug (HEV) oder in einem Plug-In-Hybridfahrzeug (PHEV).

Vorteile der Erfindung

Durch das erfindungsgemäße Verfahren wird ein Laden der Batteriezelle bei einer Temperatur unterhalb der Grenztemperatur von beispielsweise 0°C sicher verhindert. Auch wenn der gemessene Messstrom bei von der Batteriezelle getrenntem Verbraucher kleiner als der Messfehlerstrom ist, kann die Batteriezelle weiter in Betrieb bleiben. Somit kann die Batteriezelle weiterhin Kleinverbraucher im Standby-Betrieb versorgen. Somit ist ein sicherer Betrieb der Batteriezelle ermöglicht.

Kurze Beschreibung der Zeichnungen

Ausführungsformen der Erfindung werden anhand der Zeichnungen und der nachfolgenden Beschreibung näher erläutert.

Es zeigen:

Figur 1    eine schematische Darstellung einer Batteriezelle,

Figur 2    eine Schaltungsanordnung zu Ausführung des Verfahrens zum Betrieb der Batteriezelle aus Figur 1 und

Figur 3    einen beispielhaften zeitlichen Verlauf eines Messstroms in der Schaltungsanordnung aus Figur 2.

Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

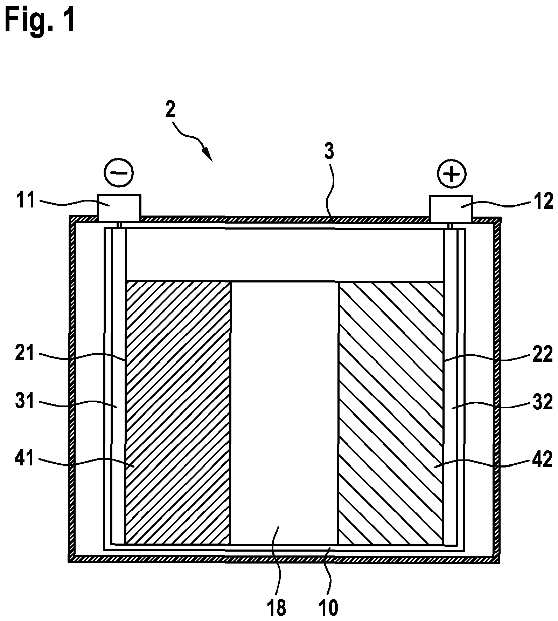

In Figur 1 ist eine Batteriezelle 2 schematisch dargestellt. Die Batteriezelle 2 umfasst ein Zellengehäuse 3, welches prismatisch, vorliegend quaderförmig, ausgebildet ist. Das Zellengehäuse 3 ist vorliegend elektrisch leitend ausgeführt und beispielsweise aus Aluminium gefertigt. Das Zellengehäuse 3 kann aber auch aus einem elektrisch isolierenden Material, beispielsweise Kunststoff, gefertigt sein.

Die Batteriezelle 2 umfasst ein negatives Terminal 11 und ein positives Terminal 12. Über die Terminals 11, 12 kann eine von der Batteriezelle 2 zur Verfügung gestellte Spannung abgegriffen werden. Ferner kann die Batteriezelle 2 über die Terminals 11, 12 auch geladen werden. Die Terminals 11, 12 sind beabstandet voneinander an einer Deckfläche des prismatischen Zellengehäuses 3 angeordnet.

Innerhalb des Zellengehäuses 3 der Batteriezelle 2 ist eine Elektrodeneinheit 10 angeordnet, welche zwei Elektroden, nämlich eine Anode 21 und eine Kathode 22, aufweist. Die Anode 21 und die Kathode 22 sind jeweils folienartig ausgeführt und unter Zwischenlage eines Separators 18 zu dem Elektrodenwickel gewickelt. Es ist auch denkbar, dass mehrere Elektrodenwickel in dem Zellengehäuse 3 vorgesehen sind. Anstelle des Elektrodenwickels kann auch beispielsweise ein Elektrodenstapel vorgesehen sein.

Die Anode 21 umfasst ein anodisches Aktivmaterial 41, welches folienartig ausgeführt ist. Die Anode 21 umfasst ferner einen Stromableiter 31, welcher ebenfalls folienartig ausgebildet ist. Das anodische Aktivmaterial 41 und der Stromableiter 31 der Anode 21 sind flächig aneinander gelegt und miteinander verbunden. Der Stromableiter 31 der Anode 21 ist elektrisch leitfähig ausgeführt und aus einem Metall gefertigt, beispielsweise aus Kupfer. Der Stromableiter 31 der Anode 21 ist mittels eines Kollektors elektrisch mit dem negativen Terminal 11 der Batteriezelle 2 verbunden.

Die Kathode 22 umfasst ein kathodisches Aktivmaterial 42, welches folienartig ausgeführt ist. Die Kathode 22 umfasst ferner einen Stromableiter 32, welcher ebenfalls folienartig ausgebildet ist. Das kathodische Aktivmaterial 42 und der Stromableiter 32 der Kathode 22 sind flächig aneinander gelegt und miteinander verbunden. Der Stromableiter 32 der Kathode 22 ist elektrisch leitfähig ausgeführt und aus einem Metall gefertigt, beispielsweise aus Aluminium. Der Stromableiter 32 der Kathode 22 ist mittels eines Kollektors elektrisch mit dem positiven Terminal 12 der Batteriezelle 2 verbunden.

Die Anode 21 und die Kathode 22 sind durch den Separator 18 voneinander getrennt. Der Separator 18 ist ebenfalls folienartig ausgebildet. Der Separator 18 ist elektrisch isolierend ausgebildet, aber ionisch leitfähig, also für Lithiumionen durchlässig.

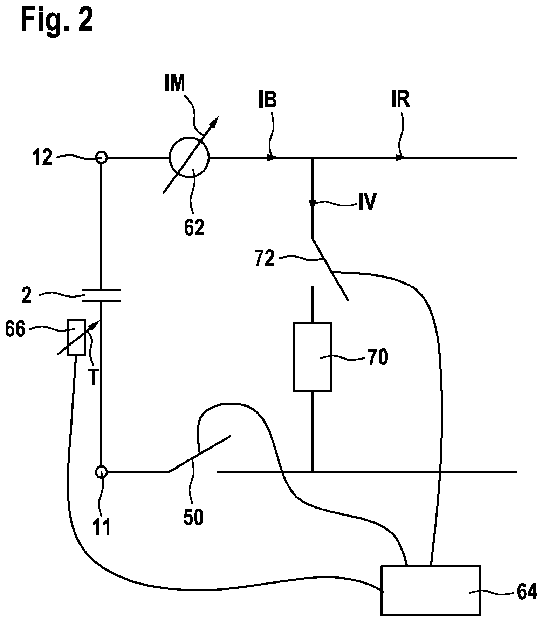

Figur 2 zeigt eine Schaltungsanordnung zu Ausführung des Verfahrens zum Betrieb der Batteriezelle 2 aus Figur 1. Die Schaltungsanordnung umfasst einen Batterieschalter 50, welcher vorliegend unmittelbar an das negative Terminal 11 der Batteriezelle 2 angeschlossen ist. Mittels des Batterieschalters 50 kann die Batteriezelle 2 zugeschaltet sowie abgeschaltet werden.

Die Schaltungsanordnung umfasst einen Stromsensor 62, welcher vorliegend unmittelbar an das positive Terminal 12 der Batteriezelle 2 angeschlossen ist. Der Stromsensor 62 dient zur Ermittlung eines durch die Batteriezelle 2 fließenden Batteriestroms IB. Wenn der Batteriestrom IB positiv ist, so wird die Batteriezelle 2 entladen, und wenn der Batteriestrom IB negativ ist, so wird die Batteriezelle 2 geladen.

Mittels des Stromsensors 62 wird ein Messstrom IM gemessen. Der Stromsensor 62 weist eine Toleranz auf, welche sich in Form eines Messfehlerstroms IF auswirkt. Der Messfehlerstrom IF ist dabei die maximale Abweichung des Messstroms IM von dem Batteriestrom IB.

Es gilt:

$$IM - IF < IB < IM + IF \qquad (A)$$

Solange also der mittels des Stromsensors 62 gemessene Messstrom IM größer als der Messfehlerstrom IF ist, ist der Batteriestrom IB mit Sicherheit positiv, und die Batteriezelle 2 wird entladen.

Die Schaltungsanordnung umfasst auch einen Verbraucher 70, welcher mittels eines Verbraucherschalters 72 mit der Batteriezelle 2 verbindbar ist. Vorliegend ist der Verbraucher 70 eine Heizung zur Erwärmung der Batteriezelle 2. Der Verbraucher 70 kann beispielsweise auch eine Heckscheibenheizung, eine Beleuchtung oder eine Balancing-Widerstand sein. Ist der Verbraucherschalter 72 geschlossen, so ist der Verbraucher 70 mit der Batteriezelle 2 verbunden und durch den Verbraucher 70 fließt ein Verbraucherstrom IV.

Der Verbraucherstrom IV ist dabei verhältnismäßig genau bekannt und weist keine wesentliche Toleranz auf. Der Verbraucherstrom IV wird von der Batteriezelle 2 geliefert. Auch ein Reststrom IR, welcher zu anderen hier nicht dargestellten Modulen fließt, wird von der Batteriezelle 2 geliefert.

Es gilt:

$$IB = IV + IR \qquad (B)$$

Die Schaltungsanordnung umfasst ferner eine Steuereinheit 64. Die Steuereinheit 64 ist mit einem Temperatursensor 66 verbunden, mittels welchem eine Temperatur T der Batteriezelle 2 gemessen wird. Der Temperatursensor 66 ist in unmittelbarer Nähe der Batteriezelle 2 angeordnet. Die Steuereinheit 64 ist auch mit dem Stromsensor 62 verbunden. Die Steuereinheit 64 ist ferner mit dem Batterieschalter 50 und mit dem Verbraucherschalter 72 verbunden. Die Steuereinheit 64 empfängt Messwerte von dem Temperatursensor 66 sowie von dem Stromsensor 62 und dient unter anderem zur Ansteuerung des Batterieschalters 50 und des Verbraucherschalters 72.

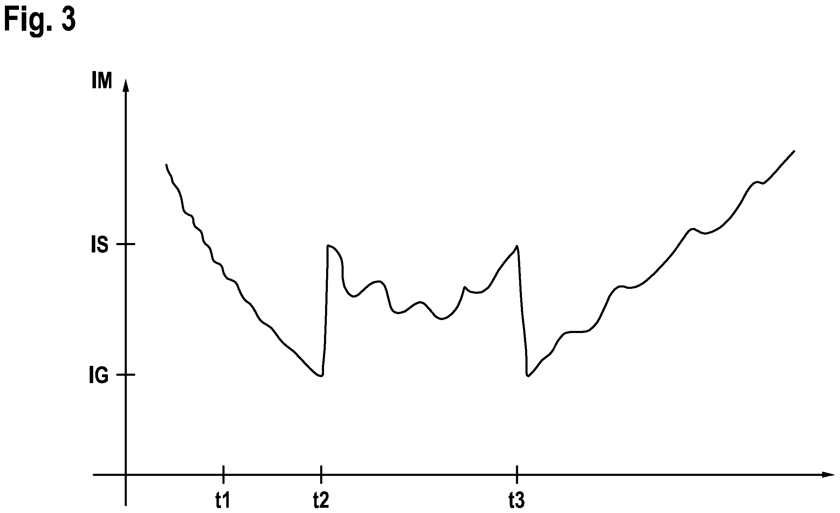

Figur 3 zeigt einen beispielhaften zeitlichen Verlauf des Messstroms IM in der Schaltungsanordnung aus Figur 2. Es wird davon ausgegangen, dass während des hier dargestellten zeitlichen Verlaufs des Messstroms IM die gemessene Temperatur T Batteriezelle 2 stets kleiner als eine Grenztemperatur TG ist. Die Grenztemperatur TG ist von der Art der Batteriezelle 2 abhängig und entspricht vorliegend einem Wert von 0°C.

Zu einem ersten Zeitpunkt t1 wird die Batteriezelle 2 entladen und der Messstrom IM ist größer als ein vorgegebener Grenzwert IG. Zu dem ersten Zeitpunkt t1 ist der Verbraucherschalter 72 geöffnet und der Verbraucher 70 ist von der Batteriezelle 2 getrennt. Der Verbraucherstrom IV ist somit null. Der Grenzwert IG entspricht dabei dem Messfehlerstrom IF des Stromsensors 62.

Es gilt:

$$IG = IF \qquad (C)$$

Mit Gleichung (A) ergibt sich: IB > IM - IG > 0

Zu einem zweiten Zeitpunkt t2 unterschreitet der Messstrom IM den vorgegebenen Grenzwert IG. Daraufhin wird der Verbraucherschalter 72 geschlossen, und der Verbraucher 70 wird mit der Batteriezelle 2 verbunden. Unmittelbar danach fließt der Verbraucherstrom IV durch den Verbraucher 70. Die Batteriezelle 2 liefert somit zusätzlich den durch den Verbraucher 70 fließenden Verbraucherstrom IV, wodurch der Messstrom IM um den Verbraucherstrom IV erhöht wird. Der Verbraucherstrom IV ist dabei vorliegend größer als der Grenzwert IG.

Es gilt:

$$IV > IG \qquad (D)$$

Mit Gleichungen (A) und (C) ergibt sich: IB > IM - IG > IV - IG > 0

Zwischen dem zweiten Zeitpunkt t2 und einem dritten Zeitpunkt t3 schwankt der Messstrom IM. Dabei bleibt der Messstrom IM aber stets größer als der vorgebene Grenzwerts IG.

Zu dem dritten Zeitpunkt t3 überschreitet der Messstrom IM einen vorgegebenen Schwellwert IS. Daraufhin wird der Verbraucherschalter 72 geöffnet, und dadurch wird der Verbraucher 70 von der Batteriezelle 2 getrennt. Unmittelbar danach ist der Verbraucherstrom IV somit wieder null, und der Messstrom IM ist um den Verbraucherstrom IV erniedrigt. Der vorgegebene Schwellwert IS entspricht dabei vorliegende der Summe des vorgegebenen Grenzwerts IG und des Verbraucherstroms IV.

Es gilt:

$$IS = IG + IV \qquad (E)$$

Mit Gleichungen (A) und (C) ergibt sich: IB > IM - IG > IS - IV - IG > 0

Falls zwischen dem zweiten Zeitpunkt t2 und dem dritten Zeitpunkt t3, während der Verbraucher 70 mit der Batteriezelle 2 verbunden ist, der Messstrom IM den vorgegebenen Grenzwert IG unterschreiten sollte, so ist nicht auszuschließen, dass der Batteriestrom IB negativ ist und die Batteriezelle 2 geladen wird. In diesem Fall wird der Batterieschalter 50 geöffnet, und dadurch wird die Batteriezelle 2 abgeschaltet.

Falls zwischen dem zweiten Zeitpunkt t2 und dem dritten Zeitpunkt t3, während der Verbraucher 70 mit der Batteriezelle 2 verbunden ist, die gemessene Temperatur T die vorgegebenen Grenztemperatur TG überschreiten sollte, so darf der Batteriestrom IB negativ werden, und die Batteriezelle 2 darf geladen werden. In diesem Fall wird der Verbraucherschalter 72 geöffnet, und dadurch wird der Verbraucher 70 von der Batteriezelle 2 getrennt.

Die Erfindung ist nicht auf die hier beschriebenen Ausführungsbeispiele beschränkt. Sie ist definiert durch die unabhängigen Ansprüche.

## Patentansprüche

**1.** Verfahren zum Betrieb einer Batteriezelle (2), insbesondere in einem Fahrzeug, wobei

mittels eines Temperatursensors (66) eine Temperatur (T) der Batteriezelle (2) gemessen wird, und
zur Ermittlung eines durch die Batteriezelle (2) fließenden Batteriestroms (IB) mittels eines Stromsensors (62) ein Messstrom (IM) gemessen wird, und wobei
ein Verbraucher (70) mit der Batteriezelle (2) verbunden wird, wodurch der Verbraucher (70) von einem Verbraucherstrom (IV) aus der Batteriezelle (2) durchflossen wird,
wenn die gemessene Temperatur (T) eine vorgegebene Grenztemperatur (TG) unterschreitet, und

wenn der gemessene Messstrom (IM) einen vorgegebenen Grenzwert (IG) unterschreitet, **dadurch gekennzeichnet, dass** der vorgegebene Grenzwert (IG) einem Messfehlerstrom (IF) des Stromsensors (62) entspricht.

**2.** Verfahren nach Anspruch 1, wobei der Verbraucherstrom (IV) mindestens so groß ist wie der vorgegebene Grenzwert (IG).

**3.** Verfahren nach einem der vorstehenden Ansprüche, wobei der Verbraucher (70) von der Batteriezelle (2) getrennt wird, wenn der gemessene Messstrom (IM) einen vorgegebenen Schwellwert (IS) überschreitet.

**4.** Verfahren nach Anspruch 3, wobei der vorgegebene Schwellwert (IS) der Summe des vorgegebenen Grenzwerts (IG) und des Verbraucherstroms (IV) entspricht.

**5.** Verfahren nach einem der vorstehenden Ansprüche, wobei die Grenztemperatur (TG) einem Wert von 0°C entspricht.

**6.** Verfahren nach einem der vorstehenden Ansprüche, wobei der Verbraucher (70) von der Batteriezelle (2) getrennt wird, wenn die gemessene Temperatur (T) die Grenztemperatur (TG) überschreitet.

**7.** Verfahren nach einem der vorstehenden Ansprüche, wobei der Verbraucher (70) eine Heizung zur Erwärmung der Batteriezelle (2) ist.

**8.** Verfahren nach einem der vorstehenden Ansprüche, wobei

die Batteriezelle (2) abgeschaltet wird, wenn bei mit der Batteriezelle (2) verbundenem Verbraucher (70) der gemessene Messstrom (IM) den vorgegebenen Grenzwert (IG) unterschreitet.

**9.** Verwendung des Verfahrens nach einem der vorstehenden Ansprüche in einem Elektrofahrzeug (EV), in einem Hybridfahrzeug (HEV) oder in einem Plug-In-Hybridfahrzeug (PHEV).

## Claims

**1.** Method for operating a battery cell (2), in particular in a vehicle, wherein

a temperature (T) of the battery cell (2) is measured by means of a temperature sensor (66), and

a measurement current (IM) is measured by means of a current sensor (62) to determine a battery current (IB) flowing through the battery cell (2),

and wherein

a load (70) is connected to the battery cell (2), as a result of which a load current (IV) from the battery cell (2) flows through the load (70)

if the measured temperature (T) falls below a predefined limit temperature (TG), and

if the measured measurement current (IM) falls below a predefined limit value (IG), **characterized in that** the predefined limit value (IG) corresponds to a measurement fault current (IF) of the current sensor (62).

2. Method according to Claim 1, wherein the load current (IV) is at least as large as the predefined limit value (IG).

3. Method according to either of the preceding claims, wherein the load (70) is disconnected from the battery cell (2) if the measured measurement current (IM) exceeds a predefined threshold value (IS).

4. Method according to Claim 3, wherein the predefined threshold value (IS) corresponds to the sum of the predefined limit value (IG) and the load current (IV).

5. Method according to one of the preceding claims, wherein the limit temperature (TG) corresponds to a value of 0°C.

6. Method according to one of the preceding claims, wherein the load (70) is disconnected from the battery cell (2) if the measured temperature (T) exceeds the limit temperature (TG).

7. Method according to one of the preceding claims, wherein the load (70) is a heating means for heating the battery cell (2).

8. Method according to one of the preceding claims, wherein

the battery cell (2) is switched off if the measured measurement current (IM) falls below the predefined limit value (IG) when the load (70) is connected to the battery cell (2).

9. Use of the method according to one of the preceding claims in an electric vehicle (EV), in a hybrid vehicle (HEV) or in a plug-in hybrid vehicle (PHEV).

**Revendications**

1. Procédé permettant de faire fonctionner un élément de batterie (2), en particulier dans un véhicule, dans lequel

une température (T) de l'élément de batterie (2) est mesurée au moyen d'un capteur de température (66), et

un courant de mesure (IM) est mesuré au moyen d'un capteur de courant (62) pour déterminer un courant de batterie (IB) circulant par l'élément de batterie (2), et dans lequel

un consommateur (70) est relié à l'élément de batterie (2) de sorte que le consommateur (70) est parcouru par un courant de consommateur (IV) provenant de l'élément de batterie (2),

si la température mesurée (T) soupasse une température limite prédéfinie (TG), et

si le courant de mesure (IM) mesuré soupasse une valeur limite (IG) prédéfinie,

**caractérisé en ce que** la valeur limite (IG) prédéfinie correspond à un courant de défaut de mesure (IF) du capteur de courant (62).

2. Procédé selon la revendication 1, dans lequel le courant de consommateur (IV) est au moins aussi grand que la valeur limite (IG) prédéfinie.

3. Procédé selon l'une quelconque des revendications précédentes, dans lequel le consommateur (70) est déconnecté de l'élément de batterie (2) si le courant de mesure (IM) mesuré dépasse une valeur seuil (IS) prédéfinie.

4. Procédé selon la revendication 3, dans lequel la valeur seuil (IS) prédéfinie correspond à la somme de la valeur limite (IG) prédéfinie et du courant de consommateur (IV).

5. Procédé selon l'une quelconque des revendications précédentes, dans lequel la température limite (TG) correspond à une valeur de 0 °C.

6. Procédé selon l'une quelconque des revendications précédentes, dans lequel le consommateur (70) est déconnecté de l'élément de batterie (2) si la température (T) mesurée dépasse la température limite (TG) .

7. Procédé selon l'une quelconque des revendications précédentes, dans lequel le consommateur (70) est un dispositif de chauffage servant à chauffer l'élément de batterie (2).

8.  Procédé selon l'une quelconque des revendications précédentes, dans lequel l'élément de batterie (2) est débranché si le courant de mesure (IM) mesuré soupasse la valeur limite (IG) prédéfinie lorsque le consommateur (70) est relié à l'élément de batterie (2) .

9.  Utilisation du procédé selon l'une quelconque des revendications précédentes dans un véhicule électrique (EV), dans un véhicule hybride (HEV) ou dans un véhicule électrique hybride rechargeable (PHEV).

# Fig. 1

# Fig. 2

**Fig. 3**

EP 3 513 208 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2013257350 A1